# EUROPEAN PATENT SPECIFICATION

(11) **EP 2 937 444 B1**
(45) Date of publication and mention of the grant of the patent: **16.08.2017**
(21) Application number: 13865990.9
(22) Date of filing: 12.12.2013
(51) Int. Cl.: C23C 14/34, C22C 5/06

(54) **AG-IN ALLOY SPUTTERING TARGET**
AG-IN-LEGIERUNGS-SPUTTERTARGET
CIBLE DE PULVÉRISATION EN ALLIAGE AG-IN

(30) Priority: 21.12.2012 JP 2012279065; 25.10.2013 JP 2013221977
(43) Date of publication of application: 28.10.2015
(73) Proprietor: Mitsubishi Materials Corporation, Chiyoda-ku Tokyo 100-8117 (JP)
(72) Inventor: NONAKA, Sohei, Sanda-shi Hyogo 669-1339 (JP); KOMIYAMA, Shozo, Sanda-shi Hyogo 669-1339 (JP)
(74) Representative: Hoffmann Eitle
(86) International application number: PCT/JP2013/083334
(87) International publication number: WO 2014/097961

(56) References cited:
- EP-A1- 1 371 749
- EP-A1- 1 712 647
- WO-A1-02/077317
- WO-A1-03/100112
- WO-A1-2005/056848
- WO-A1-2005/056848
- WO-A1-2012/137461
- WO-A1-2012/137461
- WO-A1-2013/099736
- JP-A- 2003 138 322
- JP-A- 2003 160 859
- JP-A- 2011 100 719
- JP-A- 2012 219 305
- JP-A- 2013 142 163
- US-A1- 2006 182 991

## Description

### TECHNICAL FIELD

The present invention relates to a Ag alloy sputtering target that is used to form a reflection electrode film that is used in an organic light-emitting diode (OLED) element or a light-emitting diode (LED).

### BACKGROUND ART

In an OLED display device, a light extraction type of an OLED element is classified into a bottom emission type in which light is extracted from a transparent substrate side, and a top emission type in which light is extracted from a side opposite to the substrate. The top emission type in which an opening ratio is high is advantageous for high luminance. In a top emission type OLED element of the related art, as a metal film of an anode, a reflection electrode film formed from Al, an Al alloy, Ag, or a Ag alloy is used, and a transparent conductive film such as indium tin oxide (ITO) and aluminum-doped zinc oxide (AZO) is provided between the reflection electrode film and an electroluminescent (EL) layer (For example, refer to PTL 1). The transparent conductive film has characteristics in which work function is high and is provided to inject holes into the organic EL layer.

Here, it is preferable that the reflection electrode film have a high reflectance so as to efficiently reflect light emitted from the organic EL layer. In addition, it is also preferable that the reflection electrode film have low resistance as an electrode. As a material having the above-described characteristics, a Ag alloy and an Al alloy are known. When considering that an OLED element having relatively high luminance is obtained, the Ag alloy is more excellent since the Ag alloy has a high visible light reflectance. When forming the reflection electrode film as the OLED element, a sputtering method is employed, and a silver alloy sputtering target is used (for example, refer to PTL 2).

In addition, the Ag alloy film is considered to be used in a conductive film such as a lead-out interconnection of a touch panel in addition to the reflection electrode film for the OLED element. For example, when pure Ag is used as the interconnection film, migration occurs, and therefore a short-circuit defect tends to occur. Therefore, employing of the Ag alloy film is considered.

For example, as a material of the reflection electrode film, it is suggested to use an Ag alloy obtained by adding In to Ag having high reflectance and low resistance. Hardness of a target raw material is improved due to addition of In, and therefore it is possible to suppress bending during machining. Particularly, in a case of a large-sized sputtering target, it is important to suppress the bending during the machining. Furthermore, In has an effect of improving corrosion resistance and heat resistance of the reflection electrode film formed through the sputtering. The reason for the effect is considered as follows. In makes crystal grains in the reflection electrode film fine, and therefore surface roughness of the film is made to be low. In addition, In forms a solid-solution with Ag, and thus strength of crystal grains is raised, and recrystallization of the crystal grains is suppressed. Accordingly, it is possible to suppress a decrease in the reflectance of the reflection electrode film that is formed through the sputtering. The improvement in the corrosion resistance and the heat resistance of the reflection electrode film contributes to high luminance and long operation lifespan of the OLED element.

### CITATION LIST

### PATENT LITERATURE

[PTL 1] Japanese Unexamined Patent Application, First Publication No. 2006-236839
[PTL 2] PCT International Publication No. WO2002/077317

### SUMMARY OF INVENTION

### TECHNICAL PROBLEM

However, the related art also has the following problem. Characteristics such as low resistance and a high reflectance as a reflective electrode are demanded for the Ag alloy film serving as an anode in the OLED element, and the surface roughness is required to be low in order to secure soundness of the transparent conductive film that is formed in an upper layer. That is, as the surface roughness of the Ag alloy film is high, a defect is caused in the upper-layer transparent conductive film, and the electroluminescent layer including the organic EL layer that is formed in the subsequent process due to unevenness of the Ag alloy. According to this, a production yield ratio of an OLED panel decreases. In addition, sulfur contents included in a process atmosphere sulfurize the Ag alloy film, and a sulfurized region becomes a defect. This also becomes a cause of decreasing the yield ratio.

As described above, in the related art, it is difficult to obtain a Ag alloy film which has sufficiently low resistance, high reflectance, lower surface roughness, and high sulfidation resistance. Furthermore, in a case of using a conductive film in a reflective film of an LED, a reflection electrode film, and the like, there is also demand for heat resistance capable of maintaining a reflectance in a satisfactory manner against heat generation of an LED. However, the Ag alloy according to the related art has a problem in that sufficient heat resistance cannot be obtained.

Accordingly, to solve the above-described problem, aAg alloy sputtering target is suggested which is capable of forming a conductive film which has characteristics such as low resistance, high reflectance, and low surface roughness, and which has both high sulfidation resistance and heat resistance. Sb is added to the Ag alloy sputtering target that is suggested, and therefore thin Sb oxide is formed on a surface of the Ag alloy film that is formed as a film. According to this, the characteristics such as the low resistance and the high reflectance are provided, and the small surface roughness, and the high sulfidation resistance and heat resistance are achieved.

However, in a case where elements such as Sb, Sn, Mg, Pd, Ga, and Zn, in which solid solubility to Ag is high, are added to the Ag alloy sputtering target at a concentration within a solid solubility limit, abnormal electrical discharge or splashing is less likely to occur during sputtering, and therefore there is no problem during the sputtering. However, when an element in which solid-solubility to Ag is small is present, the element is oxidized, and therefore an oxide tends to be formed in the sputtering target. In the case of the Ag alloy sputtering target that is configured of a Ag-In alloy that contains the element, there is a problem in that the abnormal electrical discharge tends to occur and splashing tends to occur due to the oxide during sputtering with a large current. Accordingly, it is difficult to cope with further improvement of the high-definition of the OLED panel, and an improvement in the yield ratio thereof is also not realized.

On the other hand, in a process of manufacturing the OLED display panel, after a reflective electrode is formed by using a laminated film of ITO/Ag alloy/ITO, a partition layer containing an organic material as a main component is formed, and a heat treatment is performed for curing of the partition layer, and the like. As described above, in a case where the laminated film is subjected to the heat treatment process, there is a problem in that the reflectance of the Ag alloy reflective film decreases before and after the heat treatment.

Accordingly, the present invention has been made to solve the problem, and an object thereof is to provide a Ag-In alloy sputtering target which is capable of responding to requests for further improvement of high-definition and an improvement in a yield ratio in an OLED panel, and which is capable of further reducing the occurrence of abnormal electrical discharge and splashing. In addition, another object of the invention is to provide a Ag-In alloy sputtering target capable of limiting a decrease in a reflectance even after aAg-In alloy thin film is subjected to a heat treatment.

### SOLUTION TO PROBLEM

As described above, when an element in which solid solubility to Ag is high is added to the Ag alloy, frequency of abnormal electrical discharge or splashing is small. In contrast, with regard to a case where an element in which solid solubility to Ag is low is added to the Ag alloy, the present inventors have obtained the following finding. This element tends to segregate at a grain boundary and the like, and tends to be oxidized into an oxide due to residual oxygen and the like in a melting atmosphere. The oxide is interposed in a Ag alloy structure, and causes the abnormal electrical discharge or the splashing. In addition, it is proved that when forming a reflection electrode film configured of the Ag-In alloy by using the Ag-In alloy sputtering target, it is important to reduce the amount of an element, which tends to become an oxide, or impurities in order to reduce the occurrence of the abnormal electrical discharge or the splashing during sputtering.

Accordingly, the present inventor give attention to elements which are included in a raw material powder for producing of the sputtering target, and in which a probability of being oxidized into oxides is high due to residual oxygen and the like in the melting atmosphere, that is, Si, Cr, Fe, and Ni, and a generation of oxides which are interposed in the Ag alloy structure is suppressed by reducing the amount of Si, Cr, Fe, and Ni, thereby reducing the abnormal electrical discharge or the splashing during sputtering. In addition, when Sb is added to the Ag-In alloy in an appropriate amount, it is possible to limit a decrease in a reflectance due to a heat treatment.

The invention is obtained from the above-described findings, and the following configurations are employed in order to solve the above-described problem.
(1) An Ag-In alloy sputtering target according to the present invention consists of 0.1 at% to 1.5 at% of In and optionally 0.2 at% to 2.0 at% of Sb, with the balance being Ag and inevitable impurities. The amount of each of elements Si, Cr, Fe, and Ni is 30 ppm or less.
(2) In the Ag-In alloy sputtering target according to (1), the sum of the amounts of the elements Si, Cr, Fe, and Ni may be 90 ppm or less.
(3) In the Ag-In alloy sputtering target according to (1), the sum of the amounts of the elements Si, Cr, Fe, and Ni may be 60 ppm or less.
(4) The Ag-In alloy sputtering target according to (1) or (2) contains 0.4 at% to 1.0 at% of Sb.
(5) It is preferable that the Ag-In alloy sputtering target according to any one of (1) to (3) be produced by melting electrolytic-refinedAg and then adding In in the melted Ag.
(6) It is preferable that the Ag-In alloy sputtering target according to (1) or (2) be produced by melting electrolytic-refined Ag and then adding In and Sb in the melted Ag.

Here, the reason why a content ratio of the metal component elements in the Ag-In alloy sputtering target of the present invention is limited as described above is as follows.

### (1) In:

In has an effect of reducing surface roughness of an alloy film, and an effect of enhancing sulfidation resistance and heat resistance, and therefore In is added. However, when In is contained in the amount less than 0.1 at%, the effects are not sufficiently exhibited. On the other hand, when In is contained in the amount exceeding 1.5 at%, specific resistance of a reflection electrode film increases, and a reflectance is also decreased. Accordingly, these ranges are not preferable. Accordingly, a In content in all metal component elements contained in the Ag-In alloy sputtering target of the present invention is set to 0.1 at% to 1.5 at%.

### (2) Si, Cr, Fe, and Ni:

Elements Si, Cr, Fe, and Ni have low solid solubility to Ag, and tend to segregate at a grain boundary and the like. Therefore, these elements tend to be oxidized into oxides due to residual oxygen and the like in a melting atmosphere, and the oxides are generated to be interposed in a Ag alloy structure. The oxides become a cause of occurrence of abnormal electrical discharge and occurrence of splashing, and therefore the amount of each of the elements is reduced as much as possible.

As a method of reducing the amount of each of the elements, for example, the following method is employed. In the method, a Ag raw material with purity of a 3N level is leached in nitric acid or sulfuric acid and then is electrolytic-refined by using an electrolytic solution having a predetermined Ag concentration. According to this method, it is possible to reduce the concentration of Pb, Na, Mg, Al, P, S, Cl, K, Ca, Co, Cu, Pd, Th, U, and the like which are impurities present in the Ag raw material. Accordingly, after performing impurity analysis with respect to the Ag raw material, in which the impurities are reduced according to the refining method, by using an inductively coupled plasma (ICP) method, the Ag raw material in which a concentration (the amount) of each of Si, Cr, Fe, and Ni is 30 ppm or less, is set as a raw material that is used to produce the Ag-In alloy sputtering target.

Here, in the present invention, the reason why the amount of each of Si, Cr, Fe, and Ni is set to 30 ppm or less is as follows. When the amount of each of the element exceeds 30 ppm, a lot of oxides are interposed in the Ag alloy structure, and therefore it is difficult to suppress the occurrence of abnormal electrical discharge and occurrence of splashing during sputtering. More preferably, the amount of the element is 10 ppm or less. In addition, even when the amount of each of the elements is 30 ppm or less, if the sum of the amounts of the elements exceeds 90 ppm, the result is not different from a case where a lot of oxides are interposed in the Ag alloy structure. Accordingly, the sum of the amounts is set to 90 ppm or less, and more preferably 60 ppm or less.

### (3) Sb:

With regard to a Ag-In alloy film that is formed in a film through sputtering using the Ag-In alloy sputtering target, if a heat treatment is performed during a process of forming a laminated film, roughness of a film surface tends to increases, and therefore reflectance of the Ag-In alloy after the heat treatment decreases in comparison to reflectance before the heat treatment. Therefore, 0.2 at% to 2.0 at% of Sb is additionally contained in the Ag-In alloy sputtering target, thereby limiting a decrease in the reflectance before and after the heat treatment. When the amount of Sb added to the Ag-In alloy sputtering target is less than 0.2 at% or exceeds 2.0 at%, it is difficult to obtain the effect of limiting the decrease in the reflectance after the heat treatment. Accordingly, the amount of Sb added to the Ag-In alloy sputtering target is set to 0.2 at% to 2.0 at%. More preferably, a range of Sb is set to 0.4 at% to 1.0 at%.

### ADVANTAGEOUS EFFECTS OF INVENTION

As described above, the Ag-In alloy sputtering target according to the present invention contains 0.1 at% to 1.5 at% of In, and the balance including Ag and inevitable impurities. In addition, the amount of each of elements Si, Cr, Fe, and Ni is 30 ppm or less. Accordingly, when forming a reflection electrode film configured of an Ag-In alloy through sputtering, it is possible to realize a further reduction in the occurrence of abnormal electrical discharge and splashing. Furthermore, the sum of the amounts of the elements Si, Cr, Fe, and Ni is 90 ppm or less. Accordingly, when forming the reflection electrode film configured of the Ag-In alloy through sputtering, it is possible to further reduce the occurrence of the abnormal electrical discharge and the splashing. In addition, 0.2 at% to 2.0 at% of Sb is added to the Ag-In alloy sputtering target. Accordingly, when forming a film through sputtering by using the sputtering target, it is possible to obtain a Ag-In alloy film in which a decrease in reflectance due to a heat treatment is limited. Accordingly, it is possible to respond to requests for further improvement of high-definition and an improvement in a yield ratio in an OLED panel, and it is possible to contribute to an improvement in productivity of a display device, a touch panel, and the like.

### DESCRIPTION OF EMBODIMENTS

Next, the Ag-In alloy sputtering target according to the present invention will be described below in detail in classification into a first embodiment and a second embodiment, specifically, with reference to Examples and Comparative Examples. In addition, the first embodiment relates to a Ag-In alloy sputtering target which is a Ag alloy containing In and in which the amount of each of Si, Cr, Fe, and Ni is 30 ppm or less, and the sum of their amounts is 90 ppm or less. The second embodiment relates to a Ag-In alloy sputtering target which is a Ag alloy containing In and Sb, and in which the amount of each of Si, Cr, Fe, and Ni is 30 ppm or less, and the sum of their amounts is 90 ppm or less.

### [First Embodiment]

First, as a raw material, Ag with purity of 99.9 mass% (3 N) or greater was prepared in order to manufacture the Ag-In alloy sputtering target according to the first embodiment of the present invention. The Ag raw material was subjected to the above-described refining method, and then a Ag raw material, which contains Si, Cr, Fe, and Ni in such a manner that the amount of each of Si, Cr, Fe, and Ni is 30 ppm or less and the sum of their amounts is 90 ppm or less in a Ag-In alloy sputtering target to be formed, was sorted. The Ag raw material that was sorted, and an In raw material with purity of 99.99 mass% or greater were weighed to obtain a predetermined composition.

Next, the Ag raw material was melted in a high vacuum or inert gas atmosphere, and a predetermined amount of In raw material was added to the resultant molten metal that was obtained. Then, the resultant mixture was melted in a vacuum or inert gas atmosphere, and an ingot, which had been melted and casted, of the Ag alloy containing In in a predetermined at% was prepared.

Here, with regard to the melting of Ag, it is preferable that an atmosphere is set to a vacuum atmosphere at once, Ag is melted in an atmosphere substituted with Ar, and then In is added to a molten metal of Ag in the Ar atmosphere from the viewpoint of stably obtaining a composition ratio between Ag and In.

The ingot that was obtained was cold-rolled, and then subjected to a heat treatment for maintaining the ingot in the air, for example, at 600°C for 2 hours. Then, the ingot was machined to prepare Ag-In alloy sputtering targets of Examples 1 to 15 and Comparative Examples 1 to 12 which have predetermined dimensions (diameter: 152.6 mm × thickness: 6 mm). Each of the sputtering targets which were prepared was soldered to a backing plate formed from oxygen-free copper. The sputtering target was mounted on an inner side of a DC magnetron sputtering apparatus, and was provided for formation of a Ag-In alloy thin film. Results obtained by performing component composition analysis with respect to the Ag-In alloy sputtering targets of Examples I to 15 and Comparative Examples 1 to 12 are shown in Table 1 and Table 2. When producing the Ag-In alloy sputtering targets of Comparative Examples 1 to 12, a Ag raw material, which was not sorted under the above-described conditions, was used. In addition, the amount of each of Si, Cr, Fe, and Ni was out of the range of the each amount in the present invention, or the sum of their amounts was out of the range of the sum of the amounts in the present invention.

Next, the inside of the DC magnetron sputtering apparatus was evacuated to 5×10⁻⁵ Pa or less by using a vacuum evacuation apparatus, and then an Ar gas was introduced therein so as to adjust a sputtering gas pressure to 0.5 Pa. Then, a DC sputtering power of, for example, 250 W was applied to a sputtering target, and continuous discharge and measurement of the number of occurrence of abnormal electrical discharge, which occurs during the discharge, were performed in the following order.

In order to measure the number of occurrence of abnormal electrical discharge during sputtering by using the Ag-In alloy sputtering target that was mounted, first, pre-sputtering was performed for one hour under the above-described conditions, thereby removing a processed layer on a target surface. In addition, sputtering was performed for one hour under the same conditions. The accumulated number of occurrence of abnormal electrical discharge, which occurred for this one hour, was measured by using an arcing count function provided to a DC power supply that was used. The measurement results are shown in a column of "the accumulated number of occurrence of abnormal electrical discharge (/h)" in Table 1 and Table 2.

**[Table 1]**

| | In (at%) | Si (ppm) | Cr (ppm) | Fe (ppm) | Ni (ppm) | Ag (at%) | Sum of the amounts of Si, Cr, Fe, and Ni (ppm) | The accumulated number of abnormal electrical discharge (/h) | Film reflectance before heat treatment test (%) | Film reflectance after heat treatment test (%) |
|---|---|---|---|---|---|---|---|---|---|---|
| Example 1 | 0.4 | 24 | 21 | 16 | 25 | Balance | 86 | 19 | 96.2 | 91.5 |
| Example 2 | 0.4 | 15 | 20 | 14 | 10 | Balance | 59 | 8 | 95.9 | 91.3 |
| Example 3 | 0.4 | 11 | 8 | 11 | 10 | Balance | 40 | 3 | 96.0 | 91.7 |
| Example 4 | 0.4 | 9 | 4 | 6 | 4 | Balance | 23 | 1 | 96.3 | 91.5 |
| Example 5 | 0.4 | 7 | 1 | 2 | 3 | Balance | 13 | 0 | 96.2 | 91.6 |
| Example 6 | 0.1 | 23 | 21 | 18 | 24 | Balance | 86 | 18 | 96.5 | 91.8 |
| Example 7 | 0.1 | 14 | 19 | 16 | 9 | Balance | 58 | 7 | 96.7 | 91.5 |
| Example 8 | 0.1 | 10 | 8 | 11 | 10 | Balance | 39 | 2 | 96.3 | 92.0 |
| Example 9 | 0.1 | 8 | 4 | 8 | 5 | Balance | 25 | 1 | 96.6 | 91.7 |
| Example 10 | 0.1 | 6 | 2 | 3 | 3 | Balance | 14 | 0 | 96.8 | 92.1 |
| Example 11 | 1.5 | 23 | 22 | 17 | 26 | Balance | 88 | 21 | 95.2 | 91.1 |
| Example 12 | 1.5 | 16 | 19 | 16 | 9 | Balance | 60 | 9 | 95.3 | 91.5 |
| Example 13 | 1.5 | 12 | 7 | 11 | 9 | Balance | 39 | 3 | 95.4 | 91.2 |
| Example 14 | 1.5 | 11 | 4 | 7 | 3 | Balance | 25 | 1 | 95.2 | 91.1 |
| Example 15 | 1.5 | 9 | 2 | 2 | 2 | Balance | 15 | 0 | 95.5 | 91.3 |

**[Table 2]**

| | In (at%) | Si (ppm) | Cr (ppm) | Fe (ppm) | Ni (ppm) | Ag (at%) | Sum of the amounts of Si, Cr, Fe, and Ni (ppm) | The accumulated number of abnormal electrical discharge (/h) | Film reflectance before heat treatment test (%) | Film reflectance after heat treatment test (%) |
|---|---|---|---|---|---|---|---|---|---|---|
| Comparative Example 1 | 0.4 | 42 | 21 | 16 | 15 | Balance | 94 | 38 | 95.8 | 91.5 |
| Comparative Example 2 | 0.4 | 25 | 39 | 15 | 16 | Balance | 95 | 45 | 96.2 | 91.2 |
| Comparative Example 3 | 0.4 | 20 | 11 | 49 | 19 | Balance | 99 | 52 | 96.1 | 91.4 |
| Comparative Example 4 | 0.4 | 20 | 14 | 22 | 40 | Balance | 96 | 41 | 95.8 | 91.0 |
| Comparative Example 5 | 0.1 | 40 | 22 | 19 | 14 | Balance | 95 | 37 | 96.7 | 91.8 |
| Comparative Example 6 | 0.1 | 23 | 42 | 15 | 18 | Balance | 98 | 45 | 96.5 | 91.6 |
| Comparative Example 7 | 0.1 | 22 | 9 | 47 | 23 | Balance | 101 | 49 | 96.6 | 92.0 |
| Comparative Example 8 | 0.1 | 19 | 14 | 25 | 39 | Balance | 97 | 40 | 96.7 | 91.9 |
| Comparative Example 9 | 1.5 | 41 | 20 | 19 | 13 | Balance | 93 | 40 | 95.6 | 91.6 |
| Comparative Example 10 | 1.5 | 24 | 40 | 15 | 17 | Balance | 96 | 46 | 95.8 | 91.4 |
| Comparative Example 11 | 1.5 | 25 | 10 | 44 | 21 | Balance | 100 | 53 | 95.5 | 91.5 |
| Comparative Example 12 | 1.5 | 18 | 11 | 17 | 49 | Balance | 95 | 44 | 95.4 | 90.9 |

As can be seen from Table 1, in direct current (DC) sputtering performed by using the Ag-In alloy sputtering targets of Examples 1 to 15, the number of occurrence of abnormal electrical discharge was reduced, and even when the abnormal electrical discharge was measured, it was confirmed that the abnormal electrical discharge occurred at a frequency without causing a problem in practical use. In contrast, as can be seen from Table 2, in Comparative Examples 1 to 12, the amount of any of Si, Cr, Fe, and Ni exceeded 30 ppm, and therefore it was confirmed that abnormal electrical discharge frequently occurred. In addition, with regard to the sum of the amounts of Si, Cr, Fe, and Ni, in Examples 1,6, and 11 in which the sum of the amounts of Si, Cr, Fe, and Ni was 90 ppm or less, and was close to 90 ppm, the number of occurrence of abnormal electrical discharge was greater than that in Examples 2 to 5, 7 to 10, and 12 to 15 in which the sum of the amounts was greatly lower than 90 ppm. In addition, in Comparative Examples 1 to 12 in which the sum of the amounts exceeded 90 ppm, the number of occurrence of abnormal electrical discharge greatly increased in comparison to Examples 1, 6, and 11. As described above, the number of occurrence of abnormal electrical discharge greatly increased with 90 ppm set as a boundary, and therefore it can be said that when the sum of the amounts of Si, Cr, Fe, and Ni is 90 ppm or less, it is possible to greatly reduce the number of occurrence of abnormal electrical discharge. In addition, in Examples 1, 6, and 11, the sum of the amounts exceeded 60 ppm, and the number of occurrence of abnormal electrical discharge was greater in comparison to other examples, and thus it can be said that the sum of the amounts is preferably 60 ppm or less.

As described above, according to the Ag-In alloy sputtering targets of Examples 1 to 15, since the amount of each of Si, Cr, Fe, and Ni is 30 ppm or less, and the sum of the amounts is 90 ppm or less, it was confirmed that it is possible to reduce the occurrence of abnormal electrical discharge. Thus, the Ag-In alloy sputtering targets can contribute to further improvement of high-definition and an improvement in a yield ratio in an OLED panel.

### [Second Embodiment]

Hereinafter, description will be given of a case of manufacturing an Ag-In alloy sputtering target according to the second embodiment of the present invention.

As is the case with the first embodiment, as a raw material to produce a target, Ag with purity of 99.9 mass% (3 N) or greater was prepared, and the Ag raw material was subjected to the above-described refining method, and then a Ag raw material, which contains Si, Cr, Fe, and Ni in such a manner that the amount of each of Si, Cr, Fe, and Ni is 30 ppm or less and the sum of their amounts is 90 ppm or less in a Ag-In alloy sputtering target to be formed, was sorted. The Ag raw material that was sorted, and an In raw material and an Sb raw material with purity of 99.99 mass% or greater were weighed to obtain a predetermined composition.

Next, the Ag raw material was melted in a high vacuum or inert gas atmosphere, and a predetermined amount of In raw material and a predetermined amount of Sb raw material were added to the resultant molten metal that was obtained. Then, the resultant mixture was melted in a vacuum or inert gas atmosphere, and an ingot, which had been melted and casted, of the Ag alloy containing In and Sb in a predetermined at% was prepared.

The ingot that was obtained was cold-rolled, and then subjected to a heat treatment for maintaining the ingot in the air, for example, at 600°C for 2 hours. Then, the ingot was machined to prepare Sb-containing Ag-In alloy sputtering targets of Examples 16 to 32 and Comparative Examples 13 to 16 which have predetermined dimensions (diameter: 152.6 mm × thickness: 6 mm). Each of the sputtering targets which were prepared was soldered to a backing plate formed from oxygen-free copper. The sputtering target was mounted on an inner side of a DC magnetron sputtering apparatus, and was provided for formation of a Ag-In-Sb alloy thin film. Results obtained by performing component composition analysis with respect to the Sb-containing Ag-In alloy sputtering targets of Examples 16 to 32, and Comparative Examples 13 to 16 are shown in Table 3 and Table 4. When manufacturing the Sb-containing Ag-In alloy sputtering targets of Comparative Examples 13 to 16, a Ag raw material, which was not sorted under the above-described conditions, was used. In addition, the amount of each of Si, Cr, Fe, and Ni was out of the range of the each amount in the present invention, or the sum of their amounts was out of the range of the sum of the amounts in the present invention.

Next, the inside of the DC magnetron sputtering apparatus was evacuated to 5×10⁻⁵ Pa or less by using a vacuum evacuation apparatus, and an Ar gas was introduced to adjust a sputtering gas pressure to 0.5 Pa. Then, DC sputtering power of, for example, 250 W was applied to a sputtering target, and continuous discharge and measurement of the number of occurrence of abnormal electrical discharge, which occurs during the discharge, were performed in the following order.

In order to measure the number of occurrence of abnormal electrical discharge during sputtering by using the Sb-containing Ag-In alloy sputtering target that was mounted, first, pre-sputtering was performed for one hour under the above-described conditions, thereby removing a processed layer on a target surface. In addition, sputtering was performed for one hour under the same conditions. The accumulated number of occurrence of abnormal electrical discharge, which occurred for this one hour, was measured by using an arcing count function provided to a DC power supply that was used. The measurement results are shown in a column of "the accumulated number of occurrence of abnormal electrical discharge (/h)" in Table 3 and Table 4.

In addition, a variation in reflectance before and after the heat treatment was measured with respect to the Ag-In alloy sputtering targets of Examples 1 to 15 and Comparative Examples I to 12, and the Sb-containing Ag-In alloy sputtering targets of Examples 16 to 32, and Comparative Examples 13 to 16.

When performing the heat treatment test, each of Ag alloy sputtering targets of Examples 1 to 32 and Comparative Examples 1 to 16, and an ITO target having a diameter of 152.4 mm × a diameter of 6 mm which is commercially available was mounted on an inner side of a chamber of a DC magnetron sputtering apparatus, and laminated structures of ITO film/Ag-In alloy film/ITO film, and ITO film/Ag-In-Sb alloy film/ITO film were prepared through sputtering.

Specifically, after the inside of sputtering apparatus was evacuated to 5×10⁻⁵ Pa or less by using a vacuum evacuation apparatus, and a film was formed on a washed glass substrate (Eagle XG, manufactured by Coming Incorporated) which was disposed to be parallel with the sputtering target and was a square 50 mm on a side, under the following sputtering conditions. The film formation was performed in the order of the ITO film, the Ag-In alloy film or the Ag-In-Sb alloy film, and the ITO film, and was continuously performed while maintaining a vacuum. Film formation conditions of the ITO film, the Ag-In alloy film, and the Ag-In-Sb alloy film are as follows.

### <ITO Film>

Power: DC 50 W
Total pressure of gas: 0.67 Pa
Gas: Ar gas and O₂ gas
Flow ratio of Ar/O₂: 50/1
Distance between a target and a substrate: 70 mm
Heating of a substrate: None
Film thickness: 10 nm,

### <Ag-In alloy film and Ag-In-Sb Alloy film>

Power: DC 250 W
Total pressure of gas: 0.3 Pa
Gas: Ar gas
Distance between a target and a substrate: 70 mm
Heating of a substrate: None
Film thickness: 350 nm

Here, compositions ofAg-In alloy films of Examples 1 to 15 and Comparative Examples 1 to 12 which are formed as a film are shown in Table 1 and Table 2. Compositions of Ag-In-Sb alloy films of Examples 16 to 32 and Comparative Examples 13 to 16 which are formed as a film are shown in Table 3 and Table 4.

### <Measurement of Reflectance>

Reflectance before the heat treatment test and reflectance after the heat treatment test were each measured with respect to ITO film/Ag-In alloy film/ITO laminated films (hereinafter, referred to as Ag-In alloy laminated films) of Examples 1 to 15 and Comparative Examples 1 to 12, and ITO film/Ag-IN-Sb alloy film/ITO laminated films (hereinafter, referred to as Ag-In-Sb alloy laminated films) of Examples 16 to 30 and Comparative Examples 13 to 16 in a wavelength range of 380 nm to 800 nm by using a spectrophotometer (U-4100, manufactured by Hitachi High-Technologies Corporation). Here, the heat treatment test was performed by a heat treatment in air at 250°C for one hour, and when measuring the reflectance, a wavelength of 550 nm was selected as a representative wavelength of visible light (380 nm to 800 nm). The reflectance that was measured with respect to the Ag-In alloy laminated films of Examples 1 to 15 are shown in a column of "film reflectance (%) before heat treatment test" and a column of "film reflectance (%) after heat treatment test" in Table 1, and the reflectance that was measured with respect to the Ag-In alloy laminated films of Comparative Examples 1 to 12 is shown in a column of "film reflectance (%) before heat treatment test" and a column of "film reflectance (%) after heat treatment test" in Table 2. In addition, the reflectance that was measured with respect to the Ag-In-Sb alloy laminated films of Examples 16 to 32 are shown in a column of "film reflectance (%) before heat treatment test" and a column of "film reflectance (%) after heat treatment test in Table 3, and the reflectance that was measured with respect to the Ag-In-Sb alloy laminated films of Comparative Examples 13 to 16 are shown in a column of "film reflectance (%) before heat treatment test" and a column of "film reflectance (%) after heat treatment test" in Table 4.

**[Table 3]**

| | In (at%) | Sb (at%) | Si (ppm) | Cr (ppm) | Fe (ppm) | Ni (ppm) | Ag (at%) | Sum of the amounts of Si, Cr, Fe, and Ni (ppm) | The accumulated number of abnormal electrical discharge (/h) | Film reflectance before heat treatment test (%) | Film reflectance after heat treatment test (%) |
|---|---|---|---|---|---|---|---|---|---|---|---|
| Example 16 | 0.4 | 0.4 | 22 | 19 | 18 | 24 | Balance | 83 | 18 | 95.8 | 95.0 |
| Example 17 | 0.4 | 0.4 | 18 | 21 | 14 | 15 | Balance | 68 | 10 | 96.0 | 94.8 |
| Example 18 | 0.4 | 0.4 | 14 | 11 | 9 | 12 | Balance | 46 | 5 | 95.5 | 94.9 |
| Example 19 | 0.4 | 0.4 | 6 | 4 | 8 | 5 | Balance | 23 | 1 | 95.8 | 95.1 |
| Example 20 | 0.4 | 0.4 | 5 | 1 | 1 | 3 | Balance | 10 | 0 | 95.6 | 95.2 |
| Example 21 | 0.4 | 0.8 | 25 | 21 | 18 | 22 | Balance | 86 | 20 | 95.5 | 95.0 |
| Example 22 | 0.4 | 0.8 | 15 | 15 | 18 | 13 | Balance | 61 | 11 | 95.4 | 95.1 |
| Example 23 | 0.4 | 0.8 | 7 | 7 | 12 | 13 | Balance | 39 | 4 | 95.7 | 95.3 |
| Example 24 | 0.4 | 0.8 | 5 | 6 | 8 | 6 | Balance | 25 | 2 | 95.3 | 95.0 |
| Example 25 | 0.4 | 0.8 | 3 | 2 | 2 | 5 | Balance | 12 | 1 | 95.6 | 94.0 |
| Example 26 | 0.4 | 1.4 | 25 | 19 | 18 | 21 | Balance | 83 | 20 | 95.2 | 93.9 |
| Example 27 | 0.4 | 1.4 | 15 | 25 | 14 | 18 | Balance | 72 | 12 | 95.3 | 93.8 |
| Example 28 | 0.4 | 1.4 | 12 | 8 | 14 | 12 | Balance | 46 | 3 | 95.6 | 94.2 |
| Example 29 | 0.4 | 1.4 | 10 | 8 | 6 | 5 | Balance | 29 | 2 | 95.1 | 93.8 |
| Example 30 | 0.4 | 1.4 | 7 | 3 | 4 | 1 | Balance | 15 | 0 | 95.5 | 94.0 |
| Example 31 | 0.4 | 0.25 | 5 | 3 | 8 | 2 | Balance | 18 | 2 | 96.1 | 92.4 |
| Example 32 | 0.4 | 1.9 | 2 | 5 | 5 | 3 | Balance | 15 | 1 | 95.3 | 93.8 |

**[Table 4]**

| | In (at%) | Sb (at%) | Si (ppm) | Cr (ppm) | Fe (ppm) | Ni (ppm) | Ag (at%) | Sum of the amounts of Si, Cr, Fe, and Ni (ppm) | The accumulated number of abnormal electrical discharge (/h) | Film reflectance before heat treatment test (%) | Film reflectance after heat treatment test (%) |
|---|---|---|---|---|---|---|---|---|---|---|---|
| Comparative Example 13 | 0.4 | 0.8 | 42 | 25 | 18 | 15 | Balance | 100 | 47 | 95.6 | 95 |
| Comparative Example 14 | 0.4 | 0.8 | 25 | 34 | 18 | 16 | Balance | 93 | 43 | 95.5 | 94.9 |
| Comparative Example 15 | 0.4 | 0.8 | 25 | 11 | 36 | 19 | Balance | 91 | 45 | 95.6 | 95.2 |
| Comparative Example 16 | 0.4 | 0.8 | 20 | 17 | 21 | 45 | Balance | 103 | 54 | 95.4 | 94.9 |

As can be seen from Table 3, in direct current (DC) sputtering performed by using the Sb-containing Ag-In alloy sputtering targets of Examples 16 to 32, the number of occurrence of abnormal electrical discharge was reduced, and even when the abnormal electrical discharge was measured, it was confirmed that the abnormal electrical discharge occurred at a frequency without a problem in practical use. Additionally, in a case of the Ag-In-Sb alloy laminated films that were formed by the Sb-containing Ag-In alloy sputtering targets of Examples 16 to 32, it was confirmed that it is possible to limit a decrease in the reflectance before and after the heat treatment test. In addition, as can be seen from Table 1, when the Ag-In alloy sputtering targets did not contain Sb, the reflectance decreased before and after the heat treatment test. In addition, as can be seen from Table 4, in the Sb-containing Ag-In alloy sputtering targets of Comparative Examples 13 to 16, the amount of any of Si, Cr, Fe, and Ni exceeded 30 ppm, and the sum of their amounts exceeded 90 ppm, and thus it was confirmed that abnormal electrical discharge frequently occurred.

As described above, as is the case with the first embodiment, according to the Sb-containing Ag-In alloy sputtering targets of Examples 16 to 32, since the amount of each of Si, Cr, Fe, and Ni is 30 ppm or less, and the sum of their amounts is 90 ppm or less, it was confirmed that it is possible to reduce the occurrence of abnormal electrical discharge, and the Sb-containing Ag-In alloy sputtering targets can contribute to further improvement of high definition and an improvement in a yield ratio in an OLED panel.

### INDUSTRIAL APPLICABILITY

According to the Ag-In alloy sputtering target of the present invention, it is possible to form an Ag alloy film which has low resistance, high reflectance, low surface roughness, and high sulfidation resistance and high heat resistance as a reflective electrode.

## Claims

1. An Ag-In alloy sputtering target consisting of:
0.1 at% to 1.5 at% of In and optionally 0.2 at% to 2.0 at% of Sb, with the balance being Ag and inevitable impurities,
wherein the amount of each of elements Si, Cr, Fe, and Ni is 30 ppm or less.

2. The Ag-In alloy sputtering target according to claim 1,
wherein the sum of the amounts of the elements Si, Cr, Fe, and Ni is 90 ppm or less.

3. The Ag-In alloy sputtering target according to claim 1,
wherein the sum of the amounts of the elements Si, Cr, Fe, and Ni is 60 ppm or less.

4. The Ag-In alloy sputtering target according to any one of claims 1 to 3,
wherein the amount of Sb is 0.4 at% to 1.0 at%.

5. The Ag-In alloy sputtering target according to any one of claims 1 to 3,
wherein the Ag-In alloy sputtering target is produced by melting electrolytic-refined Ag and then adding In in the melted Ag.

6. The Ag-In alloy sputtering target according to any one of claims 1 to 4,
wherein the Ag-In alloy sputtering target is produced by melting electrolytic-refined Ag and then adding In and Sb in the melted Ag.

## Patentansprüche

1. Ag-In-Legierung-Sputtertarget, bestehend aus:
0,1 Atom-% bis 1,5 Atom-% In und gegebenenfalls 0,2 Atom-% bis 2,0 Atom-% Sb, wobei der Rest Ag und unvermeidbare Verunreinigungen sind,
wobei die Menge jedes der Elemente Si, Cr, Fe und Ni 30 ppm oder weniger beträgt.

2. Ag-In-Legierung-Sputtertarget nach Anspruch 1,
wobei die Summe der Mengen der Elemente Si, Cr, Fe und Ni 90 ppm oder weniger ist.

3. Ag-In-Legierung-Sputtertarget nach Anspruch 1,
wobei die Summe der Mengen der Elemente Si, Cr, Fe und Ni 60 ppm oder weniger ist.

4. Ag-In-Legierung-Sputtertarget nach einem der Ansprüche 1 bis 3,
wobei die Menge von Sb 0,4 Atom% bis 1,0 Atom% beträgt.

5. Ag-In-Legierung-Sputtertarget nach einem der Ansprüche 1 bis 3,
wobei das Ag-In-Legierung-Sputtertarget durch Schmelzen von elektrolytisch raffiniertem Ag und anschließendem Zugeben von In in das geschmolzene Ag hergestellt wird.

6. Ag-In-Legierung-Sputtertarget nach einem der Ansprüche 1 bis 4,
wobei das Ag-In-Legierung-Sputtertarget durch Schmelzen von elektrolytisch raffiniertem Ag und anschließendem Zugeben von In und Sb in das geschmolzene Ag hergestellt wird.

## Revendications

1. Cible de pulvérisation en alliage Ag-In consistant en :
0,1 % atomique à 1,5 % atomique de In et facultativement 0,2 % atomique à 2,0 % atomique de Sb, le reste étant de l'Ag et des impuretés inévitables,
dans laquelle la teneur en chacun des éléments Si, Cr, Fe, et Ni est de 30 ppm ou moins.

2. Cible de pulvérisation en alliage Ag-In selon la revendication 1,
dans laquelle la somme des teneurs en éléments Si, Cr, Fe, et Ni est de 90 ppm ou moins.

3. Cible de pulvérisation en alliage Ag-In selon la revendication 1,
dans laquelle la somme des teneurs en éléments Si, Cr, Fe, et Ni est de 60 ppm ou moins.

4. Cible de pulvérisation en alliage Ag-In selon l'une quelconque des revendications 1 à 3,
dans laquelle la teneur en Sb est comprise entre 0,4 % atomique et 1,0 % atomique.

5. Cible de pulvérisation en alliage Ag-In selon l'une quelconque des revendications 1 à 3,
dans laquelle la cible de pulvérisation en alliage Ag-In est produite en faisant fondre de l'Ag raffiné électrolytiquement et ensuite en ajoutant de l'In dans l'Ag fondu.

6. Cible de pulvérisation en alliage Ag-In selon l'une quelconque des revendications 1 à 4,
dans laquelle la cible de pulvérisation en alliage Ag-In est produite en faisant fondre de l'Ag raffiné électrolytiquement et ensuite en ajoutant de l'In et du Sb dans l'Ag fondu.
